# EUROPEAN PATENT APPLICATION

(11) **EP 4 654 402 A1**
(43) Date of publication of application: **26.11.2025**
(21) Application number: 23917916.1
(22) Date of filing: 21.12.2023
(51) Int. Cl.: H02B 1/56

(54) **POWER EQUIPMENT ROOM HAVING VENTILATION DEVICE**

(30) Priority: 19.01.2023 KR 20230007776
(71) Applicant: LS Electric Co., Ltd., Gyeonggi-do 14119 (KR)
(72) Inventor: LEE, Hanjoo, Anyang-si Gyeonggi-do 14118 (KR); YANG, Hongik, Anyang-si Gyeonggi-do 14118 (KR); JO, Junyoun, Anyang-si Gyeonggi-do 14118 (KR)
(74) Representative: K&L Gates LLP
(86) International application number: PCT/KR2023/021339
(87) International publication number: WO 2024/154964

(57) **Abstract**

The present invention relates to a power equipment room having a ventilation device and, more specifically, to a power equipment room having a ventilation device to be applied to a metal distribution board having arc-resistance performance. According to the power equipment room having a ventilation device, of one embodiment of the present invention, the ventilation device is provided in a circuit breaker room so as to function as a ventilation opening by being open in a normal state, and prevents safety accidents by being closed in the event of an arc accident.

## Description

### Technical field

The disclosure relates to a power equipment room having a ventilation device, and more specifically, to a power equipment room having a ventilation device applied to a metal distribution board having arc resistance performance.

### Background Art

In general, a distribution board is a device used for monitoring, controlling, and protecting a power system. The distribution board accommodates therein various electric devices, such as a circuit breaker and a current transformer, for driving or controlling a power plant and a substation, driving an electric motor, and the like.

Among electric devices, a circuit breaker is generally used by being accommodated inside a circuit breaker room of a distribution board, and plays a role of cutting off current or allowing a flow of current to a power system.

In case that a circuit breaker is not in a good operating state or an operator is inexperienced in operating the circuit breaker, a terminal connected to a main bus may momentarily become an incomplete contact state, and arcs generated between contactors may collapse an insulation system between a high-pressure part and the ground, leading to a ground fault.

In this case, the circuit breaker cannot perform its intended function, so arcs may may continuously be generated, which may eventually lead to an internal explosion.

To protect users from explosion accidents inside circuit breakers, arc-resistant distribution boards are manufactured. The arc-resistant distribution board is designed so that arcs generated inside the circuit breaker do not affect a surrounding area. To protect users from internal arcs, the installation of ventilation holes in the arc-resistant distribution board is extremely limited, which is the main cause of increasing internal temperature of the distribution board.

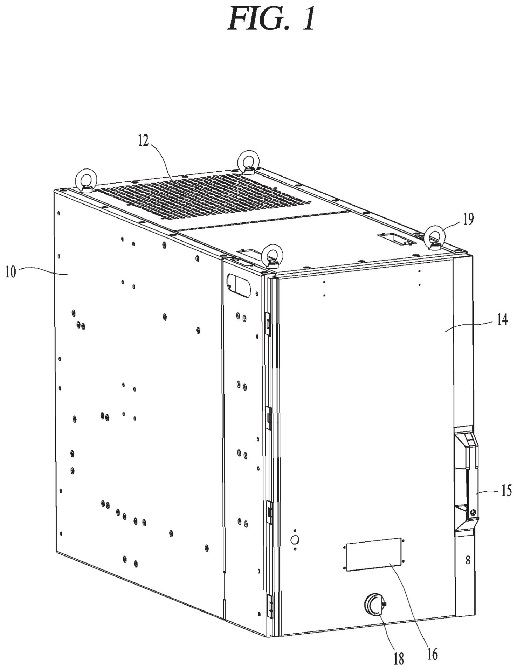

FIG. 1 shows a circuit breaker room installed in a distribution board.

A circuit breaker room or a cradle 10 for the circuit breaker is shown. A ventilator 12 is formed through an upper surface of the cradle 10, and a door 14 is installed on a front surface of the cradle 10.

The door 14 includes a door handle 15 on one side, and a view window 16 arranged on a lower portion to allow viewing of the inside. A working hole 18 is formed through a lower end portion such that a screw for drawing the circuit breaker in and out is insertable. In some embodiments, a plurality of lifting rings 19 are installed on an upper portion.

In the distribution board where an arc-resistance performance is required, the ventilator 12 at the upper surface serves to discharge arcs through a guide device, such as an arc duct, or to increase a volume to lower arc pressure.

The door 14 does not have a ventilation hole as shown in the drawing, thereby protecting a user from the arc.

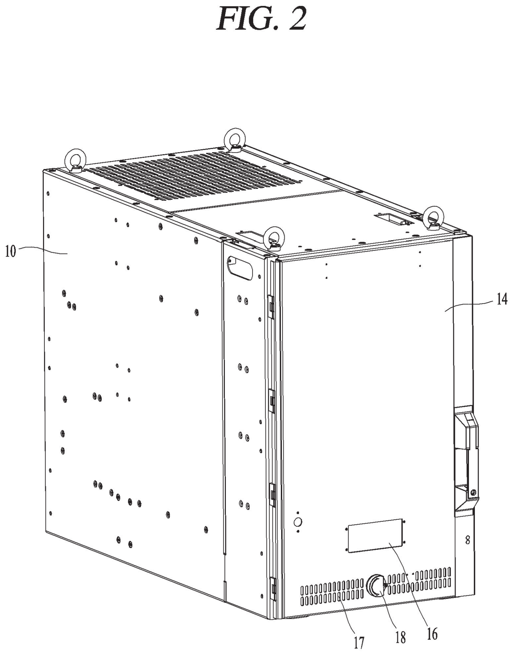

FIG. 2 shows a circuit breaker room of a distribution board where a rated current is high and arc resistance is not required. For circuits requiring high operating current, ventilation holes 17 are formed through the door 14 to reduce the increase in internal temperature due to heat generation which increases with the increase in current.

Distribution boards generally tend to have high internal temperatures as current used is high. In case that the door does not include ventilation holes formed to protect users from explosions caused by internally-generated arcs, when the distribution board using high current is operated at maximum electrical capacity, it may result in a temperature exceeding a reference temperature (approximately 90 degrees based on room temperature of 25 degrees). The exceeded temperature may accelerate the deterioration of an internal insulating material, shorten the lifespan of the distribution board, and cause other accidents due to insulation breakdown.

### Disclosure of Invention

### Technical Problem

The disclosure has been made to solve the aforementioned problems, and an aspect of the disclosure is to provide a power equipment room having a ventilation device that functions as a ventilation hole in a normal state and seals a distribution board against an explosion inside a circuit breaker room due to an arc in the event of an accident, so as to protect a user from flames.

### Solution to Problem

According to an embodiment, a power equipment room having a ventilation device includes: a power equipment room in which power equipment is accommodated; a power equipment room door installed on a front surface of the power equipment room to be open and closed, and including a ventilation hole; a fixed plate assembly fixedly coupled to a rear surface of the power equipment room door and including a ventilation opening formed to communicate with the ventilation hole; and a rotary plate assembly rotatably coupled to the fixed plate assembly.

Here, the ventilation hole is implemented as a plurality of ventilation holes.

The fixed plate assembly includes a fixed plate fixedly coupled to the rear surface of the power equipment room door, and a fixed plate frame surrounding the ventilation opening.

The rotary plate assembly includes a rotary plate rotatably coupled to the fixed plate.

A link member is arranged to connect the fixed plate assembly and the rotary plate assembly.

The link member includes a first link having one end portion coupled to a side surface portion of the fixed plate, and a second link having one end portion coupled to a side surface portion of the rotary plate and connected to the first link.

The link member further includes a connecting shaft connecting the first link and the second link.

The side surface portion of the fixed plate includes a link coupling hole to which the first link is coupled.

The side surface portion of the fixed plate provides a space in which the second link operates without interference.

The rotary plate includes an anti-interference groove formed in a side surface thereof and providing a space in which the link member operates without interference.

The rotary plate includes a fixing protrusion protruding from a side surface thereof such that one end portion of the second link is coupled.

The power equipment room further includes an elastic member arranged between the connecting shaft and the side surface portion of the fixed plate.

A lower end portion of the side surface portion of the fixed plate is bent and extends to form a wing portion, and a lower end portion of the elastic member is fixed to the wing portion.

A packing member is provided to be coupled to the fixed plate frame and to be in close contact with the rotary plate in a closed state.

### Advantageous Effects of Invention

In a power equipment room having a ventilation device according to an embodiment, the ventilation device is provided in a circuit breaker room to function as a ventilation hole by being open in a normal state, and to suppress safety accidents by being closed in the event of an arc accident.

The ventilation device includes a handle by which a user opens the ventilation device for ventilation.

The ventilation device includes a link member and an elastic member which suppress the ventilation device from being arbitrarily closed in a normal state.

The resistance of the elastic member is set so that the ventilation device is automatically closed when an arc is generated.

### Brief Description of Drawings

FIG. 1 is a perspective view of a distribution board according to an embodiment of the related art.
FIG. 2 is a perspective view of a distribution board according to another embodiment of the related art.
FIG. 3 is a perspective view of a power equipment room according to an embodiment of the disclosure.
FIG. 4 is a perspective view of a rear surface of a door of a power equipment room according to an embodiment of the disclosure.
FIG. 5 is a perspective view of a ventilation device of FIG. 4.
FIG. 6 is a perspective view of an open state of the ventilation device at the rear surface of the door of FIG. 4.
FIG. 7 is a perspective view of the ventilation device of FIG. 6.
FIG. 8 is an exploded perspective view of the ventilation device of FIG. 5.
FIG. 9 is an exploded perspective view of a fixed plate assembly in FIG. 8.
FIGS. 10 and 11 are a side view and a side perspective view of a state in which a ventilation device applied to a power equipment room according to an embodiment is in an open state.
FIGS. 12 and 13 are a side view and a side perspective view of a state in which a ventilation device applied to a power equipment room according to an embodiment is in a closed state.

### Mode for the Invention

Hereinafter, preferred embodiments of the disclosure will be described with reference to the attached drawings. However, embodiments of the disclosure will be described in more detail with reference to the accompanying drawings so as to allow those skilled in the art to easily implement the disclosure, and it should be understood that the technical idea and scope of the disclosure are not limited to those preferred embodiments and drawings.

The terms "member" or "part" used herein to refer to components are not used for any limiting purpose and may be omitted.

Hereinafter, a power equipment room having a ventilation device according to each embodiment will be described in detail.

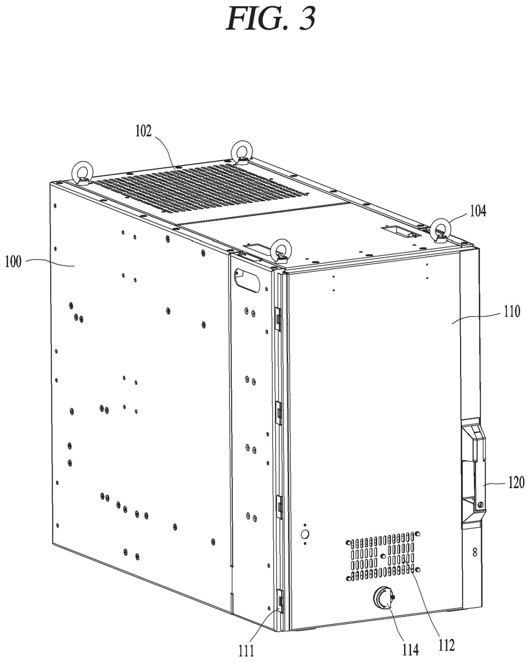

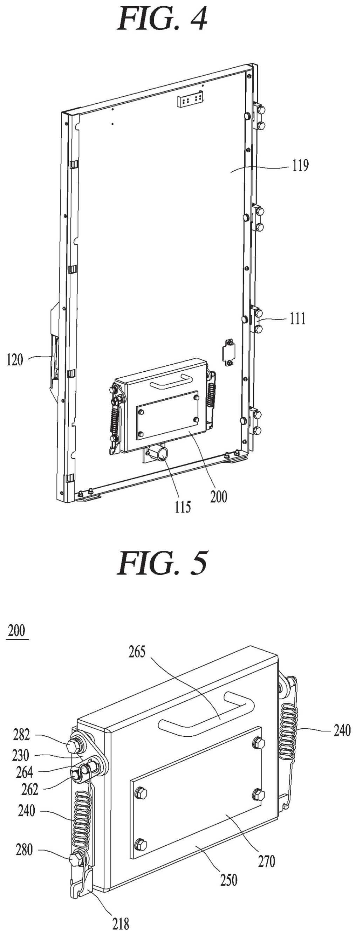

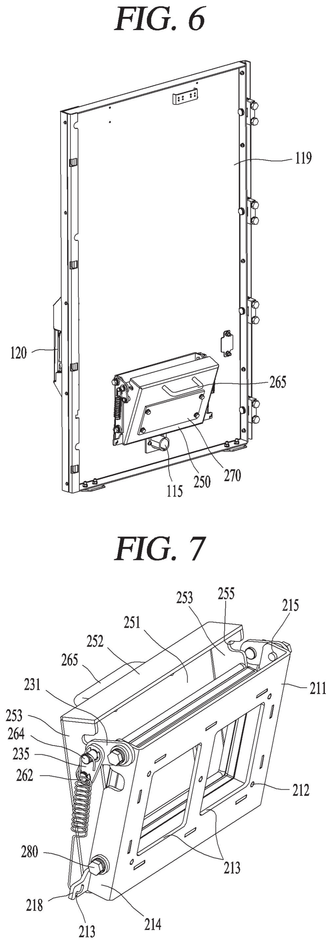

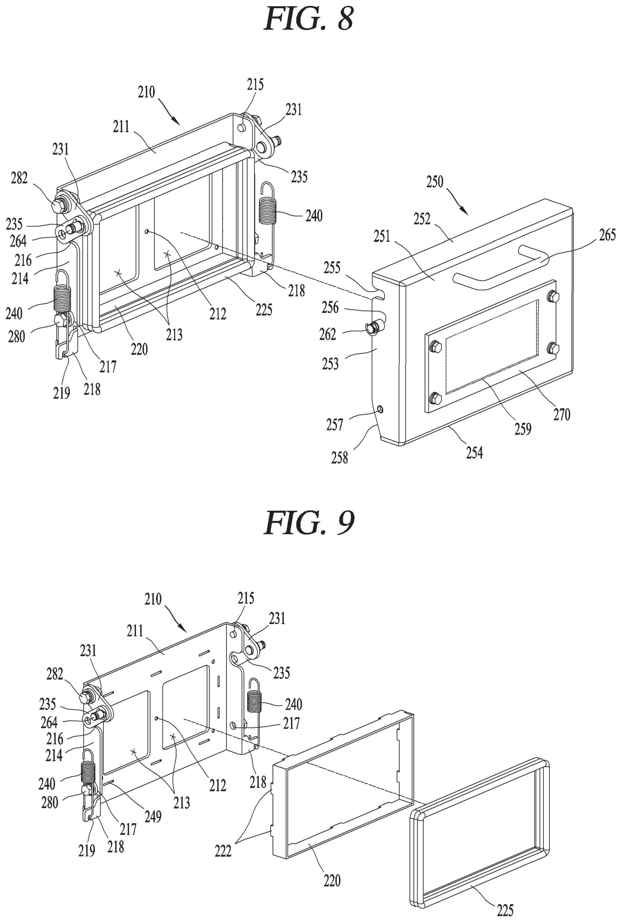

FIG. 3 is a perspective view of a power equipment room according to an embodiment, FIG. 4 is a perspective view of a rear surface of a door of a power equipment room according to an embodiment, FIG. 5 is a perspective view of a ventilation device of FIG. 4, FIG. 6 is a perspective view of an open state of the ventilation device at the rear surface of the door of FIG. 4, FIG. 7 is a perspective view of the ventilation device of FIG. 6, and FIG. 8 is an exploded perspective view of the ventilation device of FIG. 5.

A power equipment room having a ventilation device according to an embodiment includes: a power equipment room 100 in which power equipment is accommodated; a power equipment room door 110 installed on a front surface of the power equipment room 100 to be open and closed, and having a ventilation hole 112; a fixed plate assembly 210 fixedly coupled to a rear surface 119 of the power equipment room door 110 and having a ventilation opening 213 formed to communicate with the ventilation hole 112; and a rotary plate assembly 250 rotatably coupled to the fixed plate assembly 210.

The power equipment room 100 is arranged. Here, the power equipment room 100 may be a distribution board, a circuit breaker room, or a cradle. The power equipment room 100 may be formed in a box shape. The power equipment room 100 may be formed as a metal material case or a synthetic resin case.

The power equipment room 100 may accommodate power equipment, such as a circuit breaker (not shown), in which an arc is generated in the event of an accident.

A ventilator 102 is formed through an upper portion of the power equipment room 100. The ventilator 102 may include a plurality of holes.

A ring portion 104 which is a device for lifting may be installed on each corner on the upper portion of the power equipment room 100.

A power equipment room door 110 is installed on the front surface of the power equipment room 100. The power equipment room door 110 is open and closed by rotating around a portion where hinges 111 are installed.

A door handle 120 is arranged on a front surface of the power equipment room door 110 on an opposite side to the portion, on which the hinges 111 are arranged.

The ventilation hole 112 is formed through the power equipment room door 110. The ventilation hole 112 is arranged as a plurality of ventilation holes.

A working hole 114, through which a screw (not shown) for drawing a circuit breaker in and out is insertable is formed on a lower end portion of the power equipment room door 110. The working hole 114 is coupled to a guide portion 115 which protrudes from a rear surface 119 of the power equipment room door 110.

A ventilation device 200 for air ventilation is arranged in the ventilation hole 112.

The ventilation device 200 includes a fixed plate assembly 210 fixedly coupled to the rear surface 119 of the power equipment room door 110, and a rotary plate assembly 250 rotatably coupled to the fixed plate assembly 210.

Hereinafter, the fixed plate assembly 210 will be described. A description will be given additionally with reference to FIG. 9.

The fixed plate assembly 210 includes a fixed plate 211, a fixed plate frame 220, a packing member 225, a link member 230, and an elastic member 240.

The fixed plate 211 is fixedly coupled to the rear surface 119 of the power equipment room door 110. The fixed plate 211 is coupled to a portion of the ventilation hole 112.

The fixed plate 211 is formed in a plate shape and is coupled to the rear surface 119 of the power equipment room door 110. A plurality of fastening holes 212 are formed in the fixed plate 211 to couple the fixed plate 211 to the rear surface 119 of the power equipment room door 110. A plurality of frame coupling holes 249 are formed in the fixed plate 211 to which the fixed plate frame 220 is coupled.

A plurality of ventilation openings 213 are formed through a central portion of the fixed plate 211. The ventilation opening 213 communicates with the ventilation hole 112. Therefore, internal air and external air of the power equipment room 100 are joined through the ventilation hole 112 and the ventilation opening 213. The ventilation opening 213 may allow the user to visually view and recognize the interior of the power equipment room 100 from outside of the power equipment room door 110.

Opposite side surface portions 214 of the fixed plate 211 are bent. Accordingly, the fixed plate 211 is formed in a ' 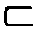 ' shape.

One end portion of the link member 230 is rotatably connected to an upper portion of each side surface portion 214. A link coupling hole 215 to which a first link 231 is coupled is formed through the corresponding side surface portion 214.

A link operation groove 216 is formed in the corresponding side surface portion 214. The link operation groove 216 provides a space in which a second link 235 and a fastening member may operate without interference.

A rotary plate fastening hole 217 is formed in a lower portion of the corresponding side surface portion 214.

A lower end portion of the side surface portion 214 is bent and extends to form a wing portion 218.

A stop groove 219 for fixing a lower end portion of the elastic member 240 is formed in the wing portion 218.

The fixed plate frame 220 is coupled to the fixed plate 211. For example, as shown in FIG. 9, the fixed plate frame 220 may be coupled to the fixed plate 211 in such a way that insertion protrusions 222 formed on one side of the fixed plate frame 220 are fitted into the frame coupling holes 249 of the fixed plate 211. The fixed plate frame 220 is formed as a rectangular tube. That is, the fixed plate frame 220 may be formed in a ' 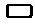 ' shape. The fixed plate frame 220 is arranged to surround the ventilation openings 213.

The packing member 225 is coupled to the fixed plate frame 220. The packing member 225 may be fitted into the fixed plate frame 220. The packing member 225 allows the fixed plate assembly 210 and the rotary plate assembly 250 to be coupled in a close contact state, reduces an impact when the rotary plate assembly 250 is coupled to the fixed plate assembly 210 (when closed), and maintains hermetic sealing in the coupled state (closed state). In case that the rotary plate assembly 250 is closed to the fixed plate assembly 210, the rotary plate 251 is in close contact with the packing member 225.

The link member 230 is arranged. The link member 230 includes a first link 231 with one end coupled to the fixed plate 211, and a second link 235 with one end coupled to the rotary plate 251.

The first link 231 has one end portion coupled to the side surface portion 214 of the fixed plate 211, and another end portion coupled to the second link 235. The another end portion of the first link 231 rotates around the one end portion of the first link 231.

The second link 235 has one end portion coupled to the rotary plate 251, and another end portion coupled to the first link 231. The another end portion of the second link 235 rotates around the one end portion of the second link 235.

A connecting shaft 264 is arranged to connect the first link 231 and the second link 235.

An elastic member 240 is provided. The elastic member 240 is arranged between the wing portion 218 of the fixed plate 211 and the link member 230.

Hereinafter, the rotary plate assembly 250 will be described.

The rotary plate assembly 250 includes a rotary plate 251, a viewing window 270, and a handle 265.

The rotary plate 251 may be formed in a box shape with one surface open. The rotary plate 251 includes an upper surface 252, opposite side surfaces 253, and a lower surface 254.

An anti-interference groove 255 is formed on each of the side surfaces 253 of the rotary plate 251 to suppress interference with the operation of the link member 230. The anti-interference groove 255 provides a space in which one end portion of the first link 231 and a fastening member may operate.

Each of the side surfaces 253 of the rotary plate 251 includes a fixing protrusion hole 256 to which a fixing protrusion 262 is coupled, and a fixed plate fastening hole 257 to which the fixed plate assembly 210 is axially coupled.

The rotary plate 251 has a viewing opening 259 formed through a center thereof. The user may check the interior through the ventilation opening 213 of the fixed plate 211 and the viewing opening 259 of the rotary plate 251.

The rotary plate 251 includes the handle 265 which is used by the user.

A viewing window 270 is arranged on the viewing opening 259 of the rotary plate 251.

A fixing protrusion 262 which is coupled to the fixing protrusion hole 256 is formed on each of the side surfaces 253 of the rotary plate 251. One end portion of the second link 235 is coupled to the fixing protrusion 262.

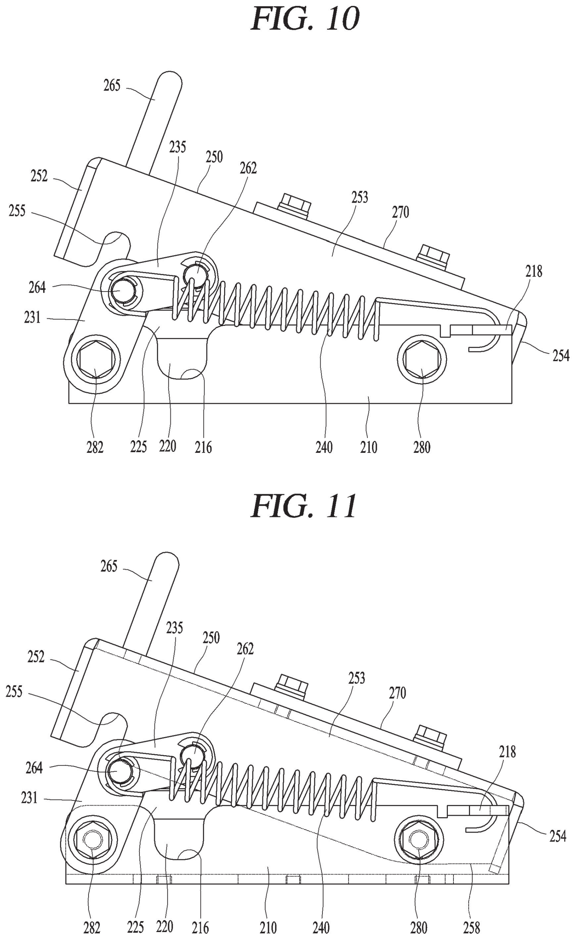

A cut portion 258 which is inclinedly cut is formed on a lower portion of each of the side surfaces 253 of the rotary plate 251. Referring to FIG. 11, the rotary plate 251 does not interfere with the fixed plate 211 by virtue of the cut portion 258 even when the rotary plate 251 is open.

A fastening member is provided.

A first fastening member 280 rotatably couples the fixed plate assembly 210 and the rotary plate assembly 250. The first fastening member 280 is axially coupled to the rotary plate fastening hole 217 of the fixed plate assembly 210 and the fixed plate fastening hole 257 of the rotary plate assembly 250.

A second fastening member 282 rotatably couples the first link 231 to the fixed plate assembly 210.

Hereinafter, the operation of a power equipment room having a ventilation device according to an embodiment will be described. The description will be given with reference to FIGS. 10 to 13.

FIGS. 10 and 11 are a side view and a side perspective view of a state in which a ventilation device is in an open state.

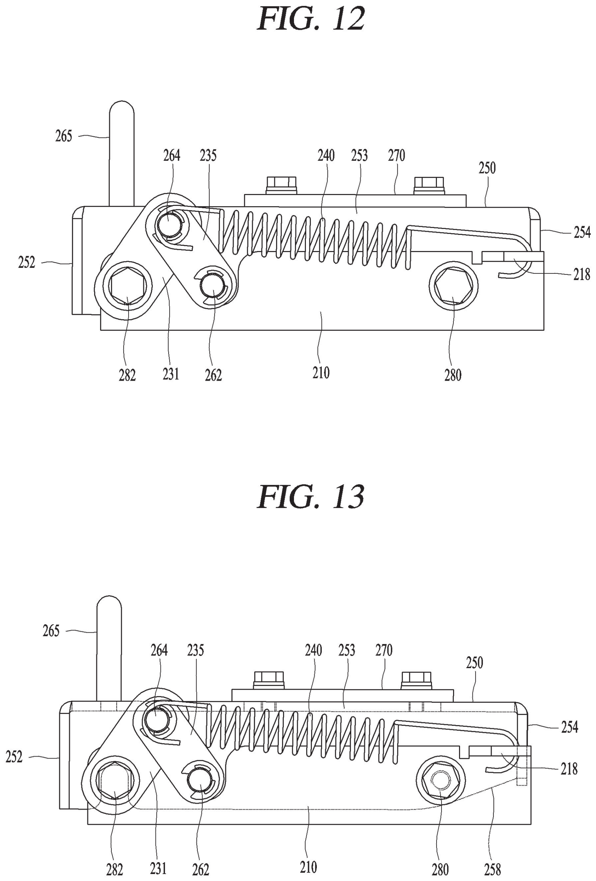

FIGS. 12 and 13 are a side view and a side perspective view of a state in which the ventilation device is in a closed state.

First, an opening operation of the ventilation device 200 will be described. When the user pulls the handle 265 in a closed state as shown in FIG. 12, the rotary plate assembly 250 is open by rotating with respect to the first fastening member 280 to be away from the fixed plate assembly 210. That is, the rotary plate assembly 250 is in an open state of FIG. 10.

At this time, the elastic member 240 is caught on the wing portion 218 of the fixed plate assembly 210 and the connecting shaft 264 of the link member 230. When the rotary plate assembly 250 is rotated to an open position as shown in FIG. 10, one end portion of the second link 235 is coupled to the fixing protrusion 262, and the fixing protrusion 262 is positioned outside a direction in which the elastic member 240 acts (a longitudinal direction of the elastic member). That is, one end portion of the first link 231 (a position of the second fastening member 282) and one end portion of the second link 235 (a position of the fixing protrusion 262) are located in opposite directions with respect to the connecting shaft 264.

The elastic member 240 is stretched, and the fixing protrusion 262 is positioned outside the direction in which the elastic member 240 acts, so that the elastic member 240 acts in a direction of pulling the connecting shaft 264. The link member 230 thus receives force in a direction of being widened. Accordingly, the link member 230 remains in the widened state, and the rotary plate assembly 250 remains in the open state relative to the fixed plate assembly 210.

Next, a closing operation of the ventilation device 200 will be described. When an arc fault occurs in the circuit breaker in the open state as shown in FIG. 10, the rotary plate assembly 250 is closed by rotating counterclockwise with respect to the first fastening member 280 due to pressure of the arc toward the fixed plate assembly 210. That is, the rotary plate assembly 250 is in a closed state of FIG. 12.

At this time, the pressure of arcs overcomes resistance of the elastic member 240 and pushes the rotary plate assembly 250 to be closed on the fixed plate assembly 210. An inner surface of the rotary plate 251 of the rotary plate assembly 250 is closed to be in close contact with the packing member 225 of the fixed plate assembly 210. Therefore, the ventilation device is sealed.

One end portion of the second link 235 and the fixing protrusion 262 are inserted into the link operation groove 216.

In the closed position as shown in FIG. 12, one end portion of the first link 231 and one end portion of the second link 235 are positioned inward relative to the direction in which the elastic member 240 acts, so that the link member 230 remains shortened (closed) and the rotary plate assembly 250 also remains in the closed state relative to the fixed plate assembly 210.

In a power equipment room having a ventilation device according to an embodiment, the ventilation device is provided in a circuit breaker room to function as a ventilation hole by being open in a normal state, and to suppress safety accidents by being closed in the event of an arc accident.

The ventilation device includes a handle by which a user opens the ventilation device for ventilation.

The ventilation device includes a link member and an elastic member which suppress the ventilation device from being arbitrarily closed in a normal state.

The resistance of the elastic member is set so that the ventilation device is automatically closed when an arc is generated.

While the above-described embodiments illustrate the best embodied state for implementing the disclosure, it will be understood by those skilled in the art that various changes and modifications may be made without departing from the scope of the disclosure. Therefore, these embodiments are not intended to limit the technical idea of the disclosure but are merely illustrative. Therefore, it should be understood that the scope of the technical idea of the disclosure is not limited by these embodiments. That is, the scope of protection of the present disclosure should be construed according to the appended claims, and all technical ideas within the scope of equivalents thereof should be construed as being included in the scope of the present disclosure.

### Description of Reference Numerals

100 Power equipment room
110 Power equipment room door
112 Ventilation hole
200 Ventilation device
210 Fixed plate assembly
211 Fixed plate
213 Ventilation opening
215 Link coupling hole
220 Fixed plate frame
225 Packing member
230 Link member
231 First link
235 Second link
240 Elastic member
250 Rotary shaft assembly
255 Anti-interference groove
258 Cut portion
259 Viewing opening
262 Fixing protrusion
264 Connecting shaft
265 Handle
270 Viewing window
280 First fastening member
282 Second fastening member

## Claims

1. A power equipment room having a ventilation device, the power equipment room comprising:
a power equipment room in which power equipment is accommodated;
a power equipment room door installed on a front surface of the power equipment room to be open and closed, and comprising a ventilation hole;
a fixed plate assembly fixedly coupled to a rear surface of the power equipment room door and comprising a ventilation opening communicating with the ventilation hole; and
a rotary plate assembly rotatably coupled to the fixed plate assembly.

2. The power equipment room of claim 1, wherein the ventilation hole is configured as a plurality of ventilation holes.

3. The power equipment room of claim 1, wherein the fixed plate assembly comprises
a fixed plate fixedly coupled to the rear surface of the power equipment room door, and
a fixed plate frame surrounding the ventilation opening.

4. The power equipment room of claim 3, wherein the rotary plate assembly comprises a rotary plate rotatably coupled to the fixed plate.

5. The power equipment room of claim 4, wherein a link member is arranged to connect the fixed plate assembly and the rotary plate assembly.

6. The power equipment room of claim 5, wherein the link member comprises
a first link having one end portion coupled to a side surface portion of the fixed plate, and
a second link having one end portion coupled to a side surface portion of the rotary plate and connected to the first link.

7. The power equipment room of claim 6, wherein the link member further comprises a connecting shaft connecting the first link and the second link.

8. The power equipment room of claim 6, wherein the side surface portion of the fixed plate comprises a link coupling hole to which the first link is coupled.

9. The power equipment room of claim 6, wherein the side surface portion of the fixed plate comprises a link operation groove providing a space in which the second link operates without interference.

10. The power equipment room of claim 6, wherein the rotary plate comprises an anti-interference groove formed in a side surface thereof and providing a space in which the link member operates without interference.

11. The power equipment room of claim 6, wherein the rotary plate comprises a fixing protrusion protruding from a side surface thereof such that one end portion of the second link is coupled.

12. The power equipment room of claim 7, further comprising an elastic member arranged between the connecting shaft and the side surface portion of the fixed plate.

13. The power equipment room of claim 12, wherein a lower end portion of the side surface portion of the fixed plate is bent and extends to form a wing portion, and a lower end portion of the elastic member is fixed to the wing portion.

14. The power equipment room of claim 4, wherein a packing member is provided to be coupled to the fixed plate frame and to be in close contact with the rotary plate in a closed state.
